# EUROPEAN PATENT APPLICATION

(11) **EP 2 345 676 A1**
(43) Date of publication of application: **20.07.2011**
(21) Application number: 09823491.7
(22) Date of filing: 19.10.2009
(51) Int. Cl.: C08F 20/34, B05D 1/28, B05D 1/38, B05D 3/00, B05D 3/06, B05D 7/24, H01L 21/027, C08G 12/40

(54) **CURABLE COMPOSITION FOR TRANSFER MATERIAL AND PATTERN FORMATION METHOD**

(30) Priority: 31.10.2008 JP 2008282040
(71) Applicant: SHOWA DENKO K.K., Minato-ku, Tokyo 105-8518 (JP)
(72) Inventor: ARAI, Yoshikazu, Tokyo 105-8518 (JP); UCHIDA, Hiroshi, Tokyo 105-8518 (JP)
(74) Representative: Strehl Schübel-Hopf & Partner
(86) International application number: PCT/JP2009/068034
(87) International publication number: WO 2010/050379

(57) **Abstract**

An object of the invention is to provide curable compositions for transfer materials suited for nanoimprinting processes, which compositions have high dry etching resistance against argon gas and high selectivity of dry etching rate between by argon gas and by oxygen gas, and can be fabricated into fine patterns used as resists or the like. A curable composition for transfer materials includes a (meth)acrylate compound having a triazine skeleton which is obtainable by reacting an aminotriazine compound, a compound having a hydroxyl group and a (meth) acryloyl group in the molecule, and an aldehyde.

## Description

### TECHNICAL FIELD

The present invention relates to energy ray-curable or heat-curable compositions for transfer materials which are patternable by imprinting processes, and to pattern forming processes using the compositions.

### BACKGROUND ART

Nanoimprinting technology attracts attention as technique capable of forming fine patterns in the manufacturing processes for semiconductors or magnetic recording media such as patterned media. There has thus been a demand for excellent transfer materials for the use therein.

Thermoplastic resins such as polymethyl methacrylate are commonly used as nanoimprinting transfer materials. In detail, conventional cycles include heating the coated material to at least the glass transition temperature thereof, pressing it with a mold, cooling, and separating the mold. Such processes, however, take a long time and have low throughput.

Such problems are addressed by a technique in which a hydrogenated silsesquioxane that is a siloxane compound is applied on a substrate and the resultant layer is pressed with a mold at room temperature to fabricate fine patterns (Patent Literature 1). A technique has been also disclosed in which a composition containing a catechol derivative and a resorcinol derivative is applied on a substrate and the resultant layer is pressed with a mold at room temperature to create fine patterns (Patent Literature 2).

These processes are referred to as the room temperature imprinting processes and can be done without heating and cooling cycles. However, the mold pressing requires a long time and the throughput is still insufficient. Further, the high pressure employed for the pressing shortens the life of stampers. Thus, these processes are not suited for mass production.

UV nanoimprinting technology has been then proposed which uses photocurable resins that are cured with UV rays. In this process, a photocurable resin is applied and is cured by UV irradiation while being pressed with a stamper, and the stamper is thereafter separated to create fine patterns. No heating and cooling cycles are necessary in this process. Further, the UV curing can be completed in a very short time, and the mold pressing can be made at low pressure. Thus, the process increases the possibility of solving the various problems described above.

The resins generally used in the UV nanoimprinting are acrylic organic resins. In the case of using the fine patterns produced as resists, the selectivity of etching rate with the variety of the dry etching gases is important. Here, the selectivity of etching rate means that the etching rate varies with the variety of the etching gases. That the resin has a high selectivity of etching rate means that the etching rate is greatly different depending on the variety of the etching gases.

When fine patterns function as a resist, the resin should be highly resistant to the etching gas but its resistance to the gas used for the resist removal should be low to permit easy removal. That is, high selectivity of etching rate is required. Frequent etching gases are fluorine-containing gases and oxygen gas. In general, organic resins do not show great difference in etching rate between by a fluorine-containing gas and by oxygen gas. Namely, the selectivity is low.

Then, silicon compounds are usually used as transfer materials in order to increase the selectivity of etching rate between by a fluorine-containing gas and by oxygen gas. One example is the use of hydrogenated silsesquioxanes described above. Fine patterns formed from hydrogenated silsesquioxanes have a high etching rate by fluorine-containing gases while the etching rate thereof by oxygen gas is very low. However, the hydrogenated silsesquioxanes do not have photocurability and cannot be used in the UV nanoimprinting processes.

To solve such problems, a technique has been proposed which uses silicon compounds with a curable functional group that are synthesized by a sol-gel process (Patent Literature 3). According to this technique, however, increasing the molecular weight of the silicon compound during the sol-gel process results in gelation and the compound becomes insoluble in solvents and infusible. Therefore, the molecular weight cannot be increased. This process thus has problems that it is difficult to balance the strength and flexibility of fine patterns during and after the imprint formation.

Further, circumstances sometimes do not allow the use of fluorine-containing gases because of problems such as corrosion. A possible alternative is argon gas. Such cases thus require selectivity of etching rate between by oxygen gas and by argon gas. Fine patterns fabricated from the aforementioned silicon compounds are not etched easily under both of these conditions, and therefore the use of the compounds is not suited for these cases. There has been accordingly a need for compounds that can form fine patterns showing high etching resistance against argon gas and low etching resistance against oxygen gas.

Patent Literature 4 addresses the brittleness of resins having a triazine skeleton such as melamine resins and discloses triazine ring-containing (meth)acrylate prepolymers and compositions thereof as materials that can give tough cured products. Patent Literature 4 describes that the materials are useful as optical materials or shaped products. However, the use of the materials as imprinting resist materials is not described.

### Citation List

### Patent Literatures

Patent Literature 1: JP-A-2003-100609
Patent Literature 2: JP-A-2005-277280
Patent Literature 3: JP-A-2007-72374
Patent Literature 4: JP-A-H07-173222

### SUMMARY OF INVENTION

### Technical Problem

It is an object of the invention to provide curable compositions for transfer materials that have high dry etching resistance against argon gas and high selectivity of dry etching rate between by argon gas and by oxygen gas, and can be fabricated into fine patterns used as resists or the like by thermal or UV nanoimprinting processes. It is another object of the invention to provide processes for forming such patterns.

### Solution to Problem

The present inventors studied diligently to achieve the above objects. They have then found that the use of (meth)acrylate compounds with a triazine skeleton described below as imprinting transfer materials leads to compositions that have good imprintability and can give cured products having excellent etching resistance which is a performance of patterned resists in the processing of underlying layers. The compositions have been found to show excellent properties in the processing of semiconductors and magnetic recording media.

The present invention has embodiments described in [1] to [17] below.
[1] A curable composition for transfer materials which comprises a (meth) acrylate compound having a triazine skeleton, the compound being obtainable by reacting an aminotriazine compound, a compound having a hydroxyl group and a (meth)acryloyl group in the molecule, and an aldehyde.
[2] A curable composition for transfer materials which comprises a (meth) acrylate compound having a triazine skeleton, the compound being obtainable by reacting an aminotriazine compound, a compound having a hydroxyl group and a (meth)acryloyl group in the molecule, an aldehyde, and a compound having a hydroxyl group and a silicon atom in the molecule.
[3] The curable composition for transfer materials described in [2], wherein the compound having a hydroxyl group and a silicon atom in the molecule is at least one selected from trimethylsilylmethanol, 2-(trimethylsilyl)ethanol, 3-(trimethylsilyl)-1-propanol, 3-(trimethylsilyl)propargyl alcohol, 4-(trimethylsilyl)-1-butanol, 4-(trimethylsilyl)-3-butyn-2-ol, 4-(trimethylsilylethynyl)benzyl alcohol, 5-(trimethylsilyl)-1-pentanol, 5-(trimethylsilyl)-4-pentyn-1-ol, 6-(trimethylsilyl)-1-hexanol, triethylsilylmethanol, 2-(triethylsilyl)ethanol, tripropylsilylmethanol, 2-(tripropylsilyl)ethanol, triisopropylsilylmethanol, 2-(triisopropylsilyl)ethanol, tributylsilylmethanol, 2-(tributylsilyl)ethanol, triphenylsilylmethanol, 2-(triphenylsilyl)ethanol, trimethylsilanol, triethylsilanol, triphenylsilanol, tert-butyldimethylsilylmethanol, 2-(tert-butyldimethylsilyl)ethanol, tert-butyldimethylsilanol, ethyldimethylsilylmethanol, 2-(ethyldimethylsilyl)ethanol, phenyldimethylsilylmethanol, 2-(phenyldimethylsilyl)ethanol and phenyldimethylsilanol.
[4] The curable composition for transfer materials described in any one of [1] to [3], wherein the aminotriazine compound is melamine.
[5] The curable composition for transfer materials described in any one of [1] to [4], wherein the compound having a hydroxyl group and a (meth)acryloyl group in the molecule is at least one selected from hydroxyethyl (meth)acrylate, 2-hydroxypropyl (meth)acrylate, 4-hydroxybutyl (meth)acrylate and 1,4-cyclohexanedimethanol mono(meth)acrylate.
[6] The curable composition for transfer materials described in any one of [1] to [5], wherein the aldehyde is at least one selected from paraformaldehyde, acetaldehyde, butylaldehyde, 3-cyclohexene-1-carboxyaldehyde, cyclohexanecarboxyaldehyde, norbornenecarboxyaldehyde, norbornanecarboxyaldehyde and benzaldehyde.
[7] The curable composition for transfer materials described in any one of [1] to [6], which further comprises a radically polymerizable compound other than the (meth)acrylate compound having a triazine skeleton.
[8] The curable composition for transfer materials described in any one of [1] to [7], which further comprises a thermal radical polymerization initiator.
[9] The curable composition for transfer materials described in any one of [1] to [7], which further comprises an active energy ray radical polymerization initiator.
[10] A pattern forming process comprising:
   a step of applying the curable composition for transfer materials described in any one of [1] to [8] to a substrate to form a coating layer;
   a step of pressing a mold having a pattern of projections and depressions on its surface, into the coating layer;
   a step of heating the coating layer while keeping the mold pressed in the coating layer, thereby to cure the coating layer; and
   a step of separating the mold from the cured coating layer.
[11] A pattern forming process comprising:
   a step of applying the curable composition for transfer materials described in any one of [1] to [7] and [9] to a substrate to form a coating layer;
   a step of pressing a mold having a pattern of projections and depressions on its surface, into the coating layer;
   a step of applying an active energy ray to the coating layer while keeping the mold pressed in the coating layer, thereby to cure the coating layer; and
   a step of separating the mold from the cured coating layer.
[12] The pattern forming process described in [11], wherein the mold is formed of a material that transmits active energy rays, and the active energy ray is applied to the coating layer through the mold.
[13] The pattern forming process described in [11], wherein the substrate is formed of a material that transmits active energy rays, and the active energy ray is applied to the coating layer through the substrate.
[14] The pattern forming process described in any one of [10] to [13], wherein the pattern is a fine pattern of 10 µm or less.
[15] A process for manufacturing magnetic recording media, comprising forming a pattern on a substrate comprising a base and a magnetic layer thereon, by the pattern forming process described in any one of [10] to [14]; and removing part of the magnetic layer or demagnetizing part of the magnetic layer using the pattern as a resist.
[16] A magnetic recording medium obtainable by the process described in [15].
[17] A magnetic recording/reading apparatus comprising the magnetic recording medium described in [16].

### Advantageous Effects of Invention

The use of the curable compositions for transfer materials according to the invention allows for the fabrication with high throughput of fine patterns having high etching resistance against argon gas and oxygen gas and also having high selectivity of dry etching rate between by argon gas and by oxygen gas.

The pattern forming processes involving the curable compositions for transfer materials according to the invention have the following three characteristics.
(1) Good transfer performance at the imprinting is achieved.
(2) The bottom of the imprinted layer of the composition may be removed to expose the magnetic layer or the cured layer may be removed by reactive ion etching using oxygen gas.
(3) In the processing of media, the layer as a resist shows good resistance to etching by argon gas.

Fine patterns in the production processes for semiconductors, magnetic recording media and the like may be fabricated by the fine pattern forming processes of the invention.

### BRIEF DESCRIPTION OF DRAWINGS

Fig. 1 shows steps for forming fine patterns of 10 µm or less using a curable composition for transfer materials according to the invention.
Fig. 2 shows a quartz glass circular plate mold used in Examples 7 to 9 in which projections and depressions are patterned along the radial direction. The width (L) of the depressions is 80 nm in the radial direction in Fig. 2, and the width (S) of the projections is 120 nm in the radial direction in the figure. In an illustration of the glass circular plate mold shown on the right side in Fig. 2, the length in the vertical (lateral) direction of the rectangles corresponding to the mold is 0.1 mm.
Fig. 3 is a field emission electron micrograph of a cross section exposed by cutting a glass substrate and a thin layer to which patterns are transferred in Example 7.
Fig. 4 is a field emission electron micrograph of a cross section exposed by cutting a glass substrate and a thin layer to which patterns are transferred in Example 8.
Fig. 5 is a field emission electron micrograph of a cross section exposed by cutting a glass substrate and a thin layer to which patterns are transferred in Example 9.
Fig. 6 shows a perforation step in the processing of a magnetic layer in a magnetic recording medium.
Fig. 7 shows an outline of partial removal or partial demagnetization of a magnetic layer in a magnetic recording medium.

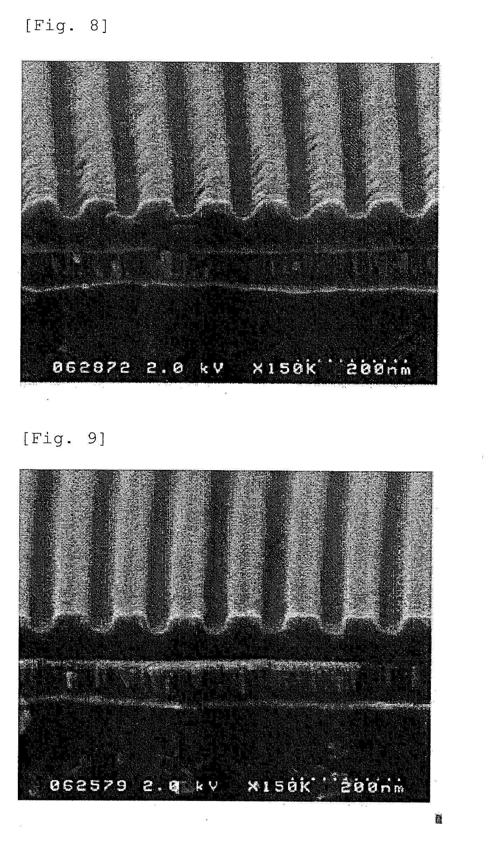

Fig. 8 is a field emission electron micrograph of a cross section exposed by cutting a glass substrate and a thin layer to which patterns are transferred in Example 13.
Fig. 9 is a field emission electron micrograph of a cross section exposed by cutting a glass substrate and a thin layer to which patterns are transferred in Example 14.

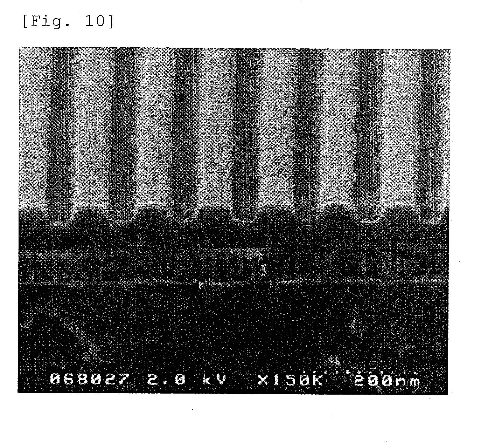

Fig. 10 is a field emission electron micrograph of a cross section exposed by cutting a glass substrate and a thin layer to which patterns are transferred in Example 15.

### DESCRIPTION OF EMBODIMENTS

The curable compositions for transfer materials according to the invention, and the pattern forming processes using the compositions will be described in detail below.

### [Curable compositions for transfer materials]

A curable composition for transfer materials of the invention includes a (meth) acrylate compound having a triazine skeleton that is obtainable by reacting an aminotriazine compound (A) such as melamine, a compound (B) having a hydroxyl group and a (meth)acryloyl group in the molecule, and an aldehyde (C) such as paraformaldehyde. Melamine is a compound in which amino groups are bonded to a triazine ring as illustrated in Formula (1) below.

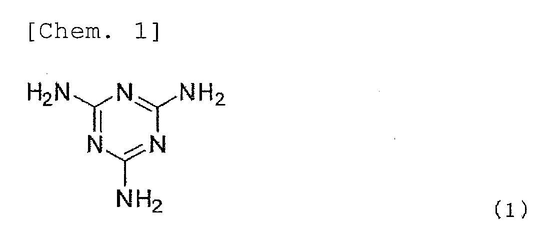

Examples of the aminotriazine compounds (A) other than melamine include 2-amino-4-ethoxy-6-methylamino-1,3,5-triazine, 3-amino-5,6-dimethyl-1,2,4-triazine, 2-amino-1,3,5-triazine, 3-amino-1,2,4-triazine, 2,4-diamino-6-phenyl-1,3,5-triazine, 2,4-diamino-6-methyl-1,3,5-triazine, 2-N-phenylamino-4,6-dimercapto-1,3,5-triazine, 2-amino-4-(2,4-difluorophenylamino)-1,3,5-triazine, 2-amino-4-methoxy-6-(methylthio)-1,3,5-triazine, 2-chloro-4,6-diamino-1,3,5-triazine, 2,4-diamino-6-undecyl-1,3,5-triazine, 2-vinyl-4,6-diamino-1,3,5-triazine and 2-amino-1,3,5-triazine-4,6-dithiol.

Of the above compounds, melamine is particularly preferable in view of its many reaction sites.

Examples of the compounds (B) having a hydroxyl group and a (meth)acryloyl group in the molecule include hydroxyalkyl (meth)acrylates such as 2-hydroxyethyl (meth)acrylate, 2-hydroxypropyl (meth)acrylate, 2-hydroxybutyl (meth)acrylate, 3-hydroxybutyl (meth)acrylate, 4-hydroxybutyl (meth)acrylate, 2-hydroxypentyl (meth)acrylate and 1,4-cyclohexanedimethanol mono(meth)acrylate;
polyhydric alcohol (meth)acrylates such as trimethylolpropane mono(meth)acrylate, glycerol mono(meth)acrylate, pentaerythritol di(meth)acrylate, pentaerythritol tri(meth)acrylate, dipentaerythritol di(meth)acrylate, dipentaerythritol tri(meth)acrylate and dipentaerythritol tetra(meth)acrylate; (meth)acrylic acid adducts of glycidyl (meth) acrylate; (meth) acrylic acid adducts of aliphatic polyepoxides such as (meth)acrylic acid adduct of glycidyl (meth)acrylate, (meth)acrylic acid (1-2 mol) adducts of dibutylene glycol diglycidyl ether (1 mol), (meth)acrylic acid (1-2 mol) adducts of polyethylene glycol diglycidyl ether (1 mol) and (meth)acrylic acid (1-2 mol) adducts of glycerol diglycidyl ether (1 mol); ε-caprolactam-modified 2-hydroxyethyl (meth)acrylate, ε-caprolactone-modified 2-hydroxyethyl (meth)acrylate, polyethylene glycol (meth)acrylate and polypropylene glycol (meth)acrylate. In the above compounds, for example, "(meth)acrylic acid (1-2 mol) adducts of dibutylene glycol diglycidyl ether (1 mol)" refer to compounds formed by the addition of 1-2 mol of (meth) acrylic acid to 1 mol of dibutylene glycol diglycidyl ether.

Examples of the aldehydes (C) include paraformaldehyde, formaldehyde, benzaldehyde, acetaldehyde, propionaldehyde, butylaldehyde, isobutylaldehyde, 1-naphthaldehyde, vinyl aldehyde, cinnamaldehyde, perillaldehyde, mesitaldehyde, 4-methoxybenzaldehyde, anisaldehyde, m-tolualdehyde, p-tolualdehyde, isophthalaldehyde, 4-fluorobenzaldehyde, 3-cyanobenzaldehyde, 3-phenoxybenzaldehyde, crotonaldehyde, 2-chlorobenzaldehyde, 3-cyclohexene-1-carboxyaldehyde, cyclohexanecarboxyaldehyde, norbornenecarboxyaldehyde and norbornanecarboxyaldehyde.

In the reaction of the aminotriazine compound (A), the compound (B) having a hydroxyl group and a (meth) acryloyl group in the molecule and the aldehyde (C), the quantitative ratio of these compounds is not particularly limited. Generally, however, the compounds (B) and (C) may be used each in an amount of 2 to 8 mol, and preferably 5 to 7 mol per 1 mol of the aminotriazine compound (A). If the ratio is outside this range, either of the compounds may not be consumed and a large amount thereof may remain unreacted, possibly causing economic disadvantages. The addition sequence of the compounds to the reaction vessel is not particularly limited, but preferably the reaction takes place after the compounds (A), (B) and (C) are all mixed together.

Dehydration condensation reaction of the aminotriazine compound (A), the compound (B) having a hydroxyl group and a (meth)acryloyl group in the molecule and the aldehyde (C) results in a composition containing a (meth) acrylate compound having a triazine skeleton. The composition contains one or more compounds in which groups such as (meth)acrylate groups, alkylether groups, methylol groups and amino groups are bonded to the triazine ring.
The composition containing a (meth)acrylate compound with a triazine skeleton that is obtainable by reacting the compounds (A), (B) and (C) can form patterns that have high etching resistance against argon gas and have high selectivity of dry etching rate between by argon gas and by oxygen gas.
The curable compositions for transfer materials of the invention include the (meth)acrylate compound having a triazine skeleton that is obtainable by reacting a mixture containing the aminotriazine compound (A) such as melamine, the compound (B) having a hydroxyl group and a (meth)acryloyl group in the molecule and the aldehyde (C) such as paraformaldehyde. The mixture may further contain a compound (D) having a hydroxyl group and a silicon atom in the molecule. The reaction of (A), (B), (C) and (D) gives a composition containing a (meth)acrylate compound with a triazine skeleton that can form patterns showing higher etching resistance against argon gas. Accordingly, the compositions containing a (meth) acrylate compound with a triazine skeleton obtainable by the reaction of (A), (B), (C) and (D) are suited for applications requiring high resistance to argon gas rather than the selectivity of etching rate between by argon gas and by oxygen gas.
Examples of the compounds (D) having a hydroxyl group and a silicon atom in the molecule include trimethylsilylmethanol, 2-(trimethylsilyl)ethanol, 3-(trimethylsilyl)-1-propanol, 3-(trimethylsilyl)propargyl alcohol, 4-(trimethylsilyl)-1-butanol, 4-(trimethylsilyl)-3-butyn-2-ol, 4-(trimethylsilylethynyl)benzyl alcohol, 5-(trimethylsilyl)-1-pentanol, 5-(trimethylsilyl)-4-pentyn-1-ol, 6-(trimethylsilyl)-1-hexanol, triethylsilylmethanol, 2-(triethylsilyl)ethanol, tripropylsilylmethanol, 2-(tripropylsilyl)ethanol, triisopropylsilylmethanol, 2-(triisopropylsilyl)ethanol, tributylsilylmethanol, 2-(tributylsilyl)ethanol, triphenylsilylmethanol, 2-(triphenylsilyl)ethanol, trimethylsilanol, triethylsilanol, triphenylsilanol, tert-butyldimethylsilylmethanol, 2-(tert-butyldimethylsilyl)ethanol, tert-butyldimethylsilanol, ethyldimethylsilylmethanol, 2-(ethyldimethylsilyl)ethanol, phenyldimethylsilylmethanol, 2-(phenyldimethylsilyl)ethanol and phenyldimethylsilanol.
In the reaction of the aminotriazine compound (A), the compound (B) having a hydroxyl group and a (meth) acryloyl group in the molecule, the aldehyde (C) and the compound (D) having a hydroxyl group and a silicon atom in the molecule, the quantitative ratio of these compounds is not particularly limited. Generally, however, the ratio per 1 mol of the aminotriazine compound (A) is such that the compound (C) is used in 2 to 8 mol, preferably 5.0 to 6.5 mol, and the compounds (B) and (D) together are used in 2 to 8 mol (B ≥ 1 mol) , preferably 5.5 to 6.5 mol (B ≥ 1 mol). If the ratio is outside this range, either of the compounds may not be consumed and a large amount thereof may remain unreacted, possibly causing economic disadvantages. If the amount of (B) is below the lower limit, the obtainable composition may have insufficient curing performance. The addition sequence of the compounds to the reaction vessel is not particularly limited, but preferably the reaction takes place after the compounds (A), (B), (C) and (D) are all mixed together.
Dehydration condensation reaction of the aminotriazine compound (A), the compound (B) having a hydroxyl group and a (meth) acryloyl group in the molecule, the aldehyde (C) and the compound (D) having a hydroxyl group and a silicon atom in the molecule results in a composition containing a silicon-containing multi-branched (meth)acrylate compound having a triazine skeleton. The composition contains one or more compounds in which groups such as (meth)acrylate groups, alkylether groups, methylol groups, amino groups and trialkylsilyl groups are bonded to the triazine ring.

In order to shorten the reaction time, a catalyst may be used in the reaction of (A), (B) and (C) or the reaction of (A) , (B) , (C) and (D). The catalysts used herein may be common catalysts that accelerate dehydration condensation reactions, such as organic or inorganic acid catalysts including paratoluenesulfonic acid, paratoluenesulfonic acid monohydrate and hydrochloric acid. When melamine is used as the aminotriazine compound (A), organic or inorganic basic catalysts such as caustic soda, sodium carbonate, ammonia and triethylamine may be used in order to increase the solubility of melamine and to accelerate the dehydration condensation reaction. Of the catalysts, the acid catalysts are preferable, and the addition amount thereof is usually 0.005 to 0.025 mol per 1 mol of the aminotriazine compound.

The reaction temperature is preferably in the range of 80 to 140°C, and more preferably 100 to 120°C. Reaction temperatures below 80°C lower the reaction rate. Above 140°C, the product tends to be thermally polymerized.

To prevent gelation during the reaction, polymerization inhibitors are preferably added. Examples of the inhibitors include phenolic compounds such as hydroquinone, p-methoxyphenol, 2-t-butylhydroquinone, 2-t-butyl-4-methoxyphenol, 2,6-di-t-butyl-4-methylphenol, 4-t-butylcatechol, 2,5-di-t-butylhydroquinone, 2,5-di-t-amylhydroquinone, 4,4'-thio-bis(6-t-butyl-m-cresol), 2,6-di-t-butyl-4-ethylphenolstearyl-β-(3,5-di-t-butyl-4-hydroxyphenyl) propionate, 2,2'-methylenebis(4-methyl-6-t-butylphenol), 4,4'-butylidenebis(3-methyl-6-t-butylphenol), 1,3,5-trimethyl-2,4,6-tris(3,5-di-t-butyl-4-hydroxybenzyl) benzene, tetrakis-[methylene-3-(3',5'-di-t-butyl-4'-hydroxyphenyl)propionate]methane, tris(3',5'-di-t-butyl-4'-hydroxybenzyl)-s-triazine-2,4,6-(1H, 3H, 5H) trione and tocopherol; sulfur compounds such as phenothiazine, styryl phenothiazine, dilauryl 3,3'-thiodipropionate, dimyristyl 3,3'-thiodipropionate, distearyl 3,3'-thiodipropionate and copper dibutyldithiocarbamate; and phosphorus compounds such as triphenyl phosphite, diphenylisodecyl phosphite and phenyldiisodecyl phosphite. These inhibitors may be used singly, or two or more kinds may be used in combination. The addition amount of the polymerization inhibitors may be 0.01 to 1 part by mass, and more preferably 0.05 to 0.2 part by mass based on 100% by mass of the reaction liquid (the total of all the components for the composition except the polymerization inhibitors). The polymerization inhibitors do not provide effects when used in amounts less than 0.01 part by mass. The use thereof in excess of 1 part by mass adversely affects the curability or color.

The reaction is preferably carried out in the presence of oxygen in order similarly to prevent polymerization. The concentration of oxygen that is present is desirably not more than 10 mol% in terms of the concentration in the gas phase in view of the explosion limit. Oxygen provides polymerization inhibitory effects even at concentrations above 10 mol%, but such concentrations easily lead to fire in the presence of an ignition source.

The reaction may involve solvents. The usable solvents include aromatic hydrocarbons such as toluene and xylene, halogenated hydrocarbons such as dichloroethane and chlorobenzene, and ester solvents such as ethyl acetate, propyl acetate, butyl acetate and propylene glycol monomethyl ether acetate.

The (meth)acrylate compounds having a triazine skeleton have a (meth)acryloyl group as a functional group. Therefore, the curable compositions for transfer materials of the invention can undergo radical polymerization or radical addition polymerization involving polyaddition of polythiols. In the specification, the term (meth)acryloyl group refers to one or more selected from the acryloyl group and the methacryloyl group.

The curable compositions for transfer materials of the invention contain the (meth)acrylate compounds having a triazine skeleton and thereby achieve excellent transfer performance in the imprinting. Cured products of the compositions show resistance in etching steps such as the Ar milling in the processing of base-medium substrates, and can be easily removed by reactive ion etching with oxygen gas when the imprinted compositions are to be perforated or separated. Further, because the curable compositions for transfer materials of the invention contain a (meth)acryloyl group as a functional group, they can be polymerized by radical polymerization.

### (Other components for curable compositions for transfer materials)

The curable compositions for transfer materials of the invention may contain a radically polymerizable compound (II) having a functional group copolymerizable with the (meth)acryloyl group of the (meth)acrylate compound (I) with a triazine skeleton described hereinabove. Exemplary radically polymerizable compounds (II) are compounds having at least one carbon-carbon double bond, in detail compounds having a (meth)acryloyloxy group, styryl group, vinyl group, allyl group, fumarate group or maleate group. Of these, compounds having a (meth)acryloyloxy group are particularly preferable, and for example monomers or oligomers having one or more (meth)acrylate structures are preferable.

The compounds having one or more (meth)acrylate structures may be monofunctional or polyfunctional (meth)acrylates. Specific examples include methyl (meth)acrylate, ethyl (meth)acrylate, n-propyl (meth)acrylate, isopropyl (meth)acrylate, n-butyl (meth)acrylate, isobutyl (meth)acrylate, sec-butyl (meth)acrylate, hexyl (meth)acrylate, octyl (meth)acrylate, 2-ethylhexyl (meth)acrylate, decyl (meth)acrylate, isobornyl (meth)acrylate, cyclohexyl (meth)acrylate, phenyl (meth)acrylate, benzyl (meth)acrylate, 2-hydroxyethyl (meth)acrylate, 2-hydroxypropyl (meth)acrylate, 3-hydroxypropyl (meth)acrylate, 2-hydroxybutyl (meth)acrylate, 2-hydroxyphenylethyl (meth)acrylate, ethylene glycol di(meth)acrylate, propylene glycol di(meth)acrylate, 1,4-butanediol di(meth)acrylate, diethylene glycol di(meth)acrylate, triethylene glycol di(meth)acrylate, trimethylolpropane di(meth)acrylate, trimethylolpropane tri(meth)acrylate, pentaerythritol penta(meth)acrylate, N,N-dimethyl (meth)acrylamide, N,N-diethyl (meth)acrylamide and N-acryloylmorpholine.

Examples of the compounds having one or more (meth) acrylate structures further include epoxy acrylates that are adducts of epoxy resins with (meth)acrylic acid, such as bisphenol A epoxy resins, hydrogenated bisphenol A epoxy resins, brominated bisphenol A epoxy resins, bisphenol F epoxy resins, novolak epoxy resins, phenol novolak epoxy resins, cresol novolak epoxy resins, alicyclic epoxy resins, N-glycidyl epoxy resins, bisphenol A novolak epoxy resins, chelated epoxy resins, glyoxal epoxy resins, amino group-containing epoxy resins, rubber-modified epoxy resins, dicyclopentadiene phenolic epoxy resins, silicone-modified epoxy resins and ε-caprolactone-modified epoxy resins.

Examples of the compounds having one or more (meth)acrylate structures further include active hydrogen-containing (meth)acrylate monomers such as urethane acrylates reacted with 2-hydroxyethyl (meth)acrylate, 2-hydroxypropyl (meth)acrylate, tripropylene glycol (meth)acrylate, 1,4-butylene glycol mono(meth)acrylate, 2-hydroxy-3-chloropropyl (meth)acrylate, glycerol mono(meth)acrylate, glycerol di(meth)acrylate, glycerol methacrylate acrylate, trimethylolpropane di(meth)acrylate and pentaerythritol tri(meth)acrylate.

Examples of the compounds having a styryl group include styrene, 2,4-dimethyl-α-methylstyrene, o-methylstyrene, m-methylstyrene, p-methylstyrene, 2,4-dimethylstyrene, 2,5-dimethylstyrene, 2,6-dimethylstyrene, 3,4-dimethylstyrene, 3,5-dimethylstyrene, 2,4,6-trimethylstyrene, 2,4,5-trimethylstyrene, pentamethylstyrene, o-ethylstyrene, m-ethylstyrene, p-ethylstyrene, o-chlorostyrene, m-chlorostyrene, p-chlorostyrene, o-bromostyrene, m-bromostyrene, p-bromostyrene, o-methoxystyrene, m-methoxystyrene, p-methoxystyrene, o-hydroxystyrene, m-hydroxystyrene, p-hydroxystyrene, 2-vinylbiphenyl, 3-vinylbiphenyl, 4-vinylbiphenyl, 1-vinylnaphthalene, 2-vinylnaphthalene, 4-vinyl-p-terphenyl, 1-vinyl anthracene, α-methylstyrene, o-isopropenyltoluene, m-isopropenyltoluene, p-isopropenyltoluene, 2,4-dimethyl-α-methylstyrene, 2,3-dimethyl-α-methylstyrene, 3,5-dimethyl-α-methylstyrene, p-isopropyl-α-methylstyrene, α-ethylstyrene, α-chlorostyrene, divinylbenzene, divinylbiphenyl and diisopropylbenzene.

Examples of the compounds having a vinyl group include (meth)acrylonitriles, derivatives thereof, vinyl esters of organic carboxylic acids and derivatives thereof (such as vinyl acetate, vinyl propionate, vinyl butyrate, vinyl benzoate and divinyl adipate).

Examples of the compounds having an allyl group include allyl acetate, allyl benzoate, diallyl adipate, diallyl terephthalate, diallyl isophthalate and diallyl phthalate.

Examples of the compounds having a fumarate group include dimethyl fumarate, diethyl fumarate, diisopropyl fumarate, di-sec-butyl fumarate, diisobutyl fumarate, di-n-butyl fumarate, di-2-ethylhexyl fumarate and dibenzyl fumarate.

Examples of the compounds having a maleate group include dimethyl maleate, diethyl maleate, diisopropyl maleate, di-sec-butyl maleate, diisobutyl maleate, di-n-butyl maleate, di-2-ethylhexyl maleate and dibenzyl maleate.

Examples of the radically curable compounds (II) having a functional group copolymerizable with the (meth)acryloyl group of the urethane acrylate compounds (I) include dialkyl itaconates, derivatives thereof (such as dimethyl itaconate, diethyl itaconate, diisopropyl itaconate, di-sec-butyl itaconate, diisobutyl itaconate, di-n-butyl itaconate, di-2-ethylhexyl itaconate and dibenzyl itaconate), N-vinylamide derivatives of organic carboxylic acids (such as N-methyl-N-vinylacetamide), maleimide and derivatives thereof (such as N-phenylmaleimide and N-cyclohexylmaleimide).

When the curable composition for transfer materials contains the (meth)acrylate compound (I) having a triazine skeleton and the radically curable compound (II) other than the (meth)acrylate compound (I) having a triazine skeleton, the quantitative ratio of these compounds is preferably 30 to 95 parts by mass of (I) and 70 to 5 parts by mass of (II), more preferably 50 to 95 parts by mass of (I) and 50 to 5 parts by mass of (II), and particularly preferably 70 to 95 parts by mass of (I) and 30 to 5 parts by mass of (II) based on 100 parts by mass of the compounds combined. The radically curable compounds other than (I) contained in the above ratio provide improved curability and adhesion of the resultant compositions.

Thermal polymerization or active energy ray polymerization may be employed to cure the (meth)acryloyl groups that are the curable functional groups in the curable compositions for transfer materials. Appropriate polymerization initiators may be added as required depending on the polymerization mode.

Examples of the thermal radical polymerization initiators usable for thermal polymerization include organic peroxides such as methyl ethyl ketone peroxide, cyclohexanone peroxide, methylcyclohexanone peroxide, methyl acetate peroxide, acetyl acetate peroxide, 1,1-bis(t-butylperoxy)butane, 1,1-bis(t-butylperoxy)-cyclohexane, 1,1-bis(t-butylperoxy)-2-methylcyclohexane, 1,1-bis(t-butylperoxy)-3,3,5-trimethylcyclohexane, 1,1-bis(t-butylperoxy)cyclododecane, 1,1-bis(t-hexylperoxy)-cyclohexane, 1,1-bis(t-hexylperoxy)-3,3,5-trimethylcyclohexane, 2,2-bis(4,4-di-t-butylperoxycyclohexyl)propane, t-butyl hydroperoxide, t-hexyl hydroperoxide, 1,1,3,3-tetramethylbutyl hydroperoxide, cumene hydroperoxide, p-methyl hydroperoxide, diisopropylbenzene hydroperoxide, di-t-butyl peroxide, dicumyl peroxide, t-butylcumyl peroxide, α,α'-bis(t-butylperoxy)diisopropylbenzene, 2,5-dimethyl-2,5-bis(t-butylperoxy)hexane, 2,5-dimethyl-2,5-bis(t-butylperoxy)hexyne-3, isobutyryl peroxide, 3,3,5-trimethylhexanoyl peroxide, octanoyl peroxide, lauroyl peroxide, stearoyl peroxide, succinic acid peroxide, m-toluoyl benzoyl peroxide, benzoyl peroxide, di-n-propyl peroxydicarbonate, diisopropyl peroxydicarbonate, bis(4-t-butylcyclohexyl) peroxydicarbonate, di-2-ethoxyethyl peroxydicarbonate, di-2-ethoxyhexyl peroxydicarbonate, di-3-methoxybutyl peroxydicarbonate, di-s-butyl peroxydicarbonate, di(3-methyl-3-methoxybutyl) peroxydicarbonate, α,α'-bis(neodecanoylperoxy)diisopropylbenzene, t-butyl peroxyneodecanoate, t-hexyl peroxyneodecanoate, 1,1,3,3-tetramethylbutyl peroxyneodecanoate, 1-cyclohexyl-1-methylethyl peroxyneodecanoate, cumyl peroxyneodecanoate, t-butyl peroxypivalate, t-hexyl peroxypivalate, t-butyl peroxy-2-ethylhexanoate, t-hexyl peroxy-2-ethylhexanoate, 1,1,3,3-tetramethylbutyl peroxy-2-ethylhexanoate, 2,5-dimethyl-2,5-bis(2-ethylhexanoylperoxy)hexane, 1-cyclohexyl-1-methylethyl peroxy-2-ethylhexanoate, t-butyl peroxy-3,5,5-trimethylhexanoate, t-butylperoxyisopropyl monocarbonate, t-hexylperoxyisopropyl monocarbonate, t-butylperoxy-2-ethylhexyl monocarbonate, t-butylperoxyallyl monocarbonate, t-butyl peroxyisobutyrate, t-butyl peroxymaleate, t-butyl peroxybenzoate, t-hexyl peroxybenzoate, t-butyl peroxy-m-toluylbenzoate, t-butyl peroxylaurate, t-butyl peroxyacetate, bis(t-butylperoxy)isophthalate, 2,5-dimethyl-2,5-bis(m-toluylperoxy)hexane, 2,5-dimethyl-2,5-bis(benzoylperoxy)hexane, t-butyltrimethylsilyl peroxide, 3,3',4,4'-tetra(t-butylperoxycarbonyl)benzophenone and 2,3-dimethyl-2,3-diphenylbutane; and azo compounds such as 1-[(1-cyano-1-methylethyl)azo]formamide, 1,1'-azobis(cyclohexane-1-carbonitrile), 2,2'-azobis(2-methylbutyronitrile), 2,2'-azobisisobutyronitrile, 2,2'-azobis(2,4-dimethyl-4-methoxyvaleronitrile), 2,2'-azobis(2,4-dimethylvaleronitrile), 2-phenylazo-4-methoxy-2,4-dimethylvaleronitrile, 2,2'-azobis(2-methylpropionamidine)dihydrochloride, 2,2-azobis(2-methyl-N-phenylpropionamidine)dihydrochloride, 2,2'-azobis[N-(4-chlorophenyl)-2-methylpropionamidine] dihydrochloride, 2,2'-azobis[N-(4-hydrophenyl)-2-methylpropionamidine] dihydrochloride, 2,2'-azobis[2-methyl-N-(2-propenyl)propionamidine] dihydrochloride, 2,2'-azobis[N-(2-hydroxyethyl)-2-methylpropionamidine] dihydrochloride, 2,2'-azobis[2-methyl-N-(phenylmethyl)propionamidine] dihydrochloride, 2,2'-azobis[2-(2-imidazolin-2-yl)propane] dihydrochloride, 2,2'-azobis[2-(2-imidazolin-2-yl)propane] dihydrochloride, 2,2'-azobis[2-(5-methyl-2-imidazolin-2-yl)propane] dihydrochloride, 2,2'-azobis{2-[1-(2-hydroxyethyl)-2-imidazolin-2-yl] propane} dihydrochloride, 2,2'-azobis[2-(4,5,6,7-tetrahydro-1H-1,3-diazepin-2-yl) propane] dihydrochloride, 2,2'-azobis[2-(3,4,5,6-tetrahydropyrimidin-2-yl)propane] dihydrochloride, 2,2'-azobis[2-(5-hydroxy-3,4,5,6-tetrahydropyrimidin-2-yl) propane] dihydrochloride, 2,2'-azobis(2-methylpropionamide), 2,2'-azobis[2-methyl-N-(2-hydroxyethyl)propionamide], 2,2'-azobis{2-methyl-N-[1,1-bis(hydroxymethyl)-2-hydroxyethyl]propionamide}, 2,2'-azobis{2-methyl-N-[1,1-bis(hydroxymethyl)ethyl] propionamide}, 2,2'-azobis(2-methylpropane), 2,2'-azobis(2,4,4-trimethylpentane), dimethyl-2,2'-azobis(2-methylpropionate), 4,4'-azobis(4-cyanopentanoic acid) and 2,2'-azobis[2-(hydroxymethyl)propionitrile].

The active energy rays used for the active energy ray curing are not particularly limited as long as the rays act on the (meth)acryloyl groups of the compounds and cure the compositions. Examples thereof include radiations such as UV rays and X-rays, and electron beams. Of these, UV rays and electron beams may be suitably used.

The acryloyl groups may be cured in the absence of the polymerization initiators as is the case when electron beams are used. However, active energy ray radical polymerization initiators are preferably added as required depending on the kinds of the active energy ray used and the functional groups in the composition.

Examples of the UV radical polymerization initiators for use in the invention include acetophenone radical photopolymerization initiators such as 4-phenoxydichloroacetophenone, 4-t-butyldichloroacetophenone, 4-t-butyltrichloroacetophenone, diethoxyacetophenone, 2-hydroxy-2-cyclohexylacetophenone, 2-hydroxy-2-phenyl-1-phenylpropan-1-one, 1-(4-dodecylphenyl)-2-hydroxy-2-methylpropan-1-one, 1-(4-isopropylphenyl)-2-hydroxy-2-methylpropan-1-one, 4-(2-hydroxyethoxy)-phenyl (2-hydroxy-2-propyl) ketone, 1-hydroxycyclohexyl phenyl ketone, 2-methyl-1-[4-(methylthio)phenyl]-2-morpholinopropan-1-one and 2-benzyl-2-dimethylamino-1-(4-morpholinophenyl)-1-butanone; benzoin radical photopolymerization initiators such as benzoin, benzoin methyl ether, benzoin isopropyl ether, benzoin isobutyl ether and benzyl methyl ketal; benzophenone radical photopolymerization initiators such as benzophenone, benzoylbenzoic acid, methyl benzoylbenzoate, 4-phenylbenzophenone, hydroxybenzophenone, acrylated benzophenone, 4-benzoyl-4'-methyldiphenyl sulfide, 3,3'-dimethyl-4-methoxybenzophenone, 4,4'-dimethylaminobenzophenone, 4,4'-diethylaminobenzophenone and 3,3',4,4'-tetra(t-butylperoxycarbonyl)benzophenone; thioxanthone radical photopolymerization initiators such as thioxanthone, 2-chlorothioxanthone, 2-methylthioxanthone, 2,4-dimethylthioxanthone, 2,4-diethylthioxanthone, 2,4-diisopropylthioxanthone, isopropylthioxanthone, 1-chloro-4-propoxythioxanthone and 2,4-dichlorothioxanthone; ketone radical photopolymerization initiators such as α-acyloxime esters, methyl phenyl glyoxylate, benzyl, 9,10-phenanthrenequinone, camphorquinone, dibenzosuberone, 2-ethylanthraquinone and 4',4"-diethylisophthalophenone; imidazol radical photopolymerization initiators such as 2,2'-bis (2-chlorophenyl)-4,4',5,5'-tetraphenyl-1,2'-imidazol; acylphosphine oxide radical photopolymerization initiators such as 2,4,6-trimethylbenzoyldiphenylphosphine oxide; carbazole radical photopolymerization initiators; and Lewis acid onium salt radical photopolymerization initiators such as triphenylphosphonium hexafluoroantimonate, triphenylphosphonium hexafluorophosphate, p-(phenylthio)phenyldiphenylsulfonium hexafluoroantimonate, 4-chlorophenyldiphenylsulfonium hexafluorophosphate and (2,4-cyclopentadien-1-yl)[(1-methylethyl)benzene]-iron-hexafluorophosphate.

These polymerization initiators may be used singly, or two or more kinds may be used in combination.

When the curable composition for transfer materials further contains the active energy ray radical polymerization initiator or the thermal radical polymerization initiator (III), the quantitative ratio of (I) and (II) is as described above, and the ratio of (III) based on 100 parts by mass of (I) and (II) combined is 0.2 to 10 parts by mass, preferably 0. 5 to 7 parts by mass, and particularly preferably 1 to 5 parts by mass. If the ratio of (III) is less than 0.2 part by mass, curability tends to be lowered. If it exceeds 10 parts by mass, properties of the obtainable coating layers tend to be deteriorated.

The curable compositions for transfer materials according to the invention may contain, in addition to the polymerization initiators, additives such as viscosity modifiers, dispersants and surface conditioners. The amount of the additives combined is preferably not more than 30% by mass of the curable composition. If the amount of the additives is too large, fine patterns obtainable from the curable composition may have deteriorated etching resistance.

The curable compositions for transfer materials may contain solvents or the like as required in order to improve application properties in the case of formation of fine patterns. The diluent solvent may be the solvent used in the reaction for the production of the urethane acrylate compounds. Alternatively, the reaction solvent may be distilled away under reduced pressure and a different solvent may be added as the diluent solvent. Examples of the solvents include ketone solvents such as methyl isobutyl ketone, aromatic hydrocarbon solvents such as toluene and xylene, ester solvents such as ethyl acetate, butyl acetate and propylene glycol monomethyl ether acetate, alcohol solvents such as 2-propanol, butanol, hexanol propylene glycol mono-n-propyl ether and ethylene glycol monoethyl ether, and amide solvents such as dimethylacetamide, dimethylformamide and n-methylpyrrolidone.

### [Pattern forming processes]

Next, there will be described processes for forming patterns using the curable compositions for transfer materials. In particular, fine patterns of 10 µm or less may be fabricated according to the processes.
Herein, the fine patterns of 10 µm or less are patterns in which the linewidth of projections and depressions imprinted with a mold is 10 µm or less. That is, one depression and one projection have a total linewidth (pitch) of not more than 10 µm.

In one embodiment, the pattern forming process according to the invention includes a step of applying the curable composition for transfer materials to a substrate to form a coating layer; a step of pressing a mold into the curable composition that has been applied to the substrate; a step of heating the curable composition while keeping the mold pressed in the composition, thereby to cure the curable composition; and a step of separating the mold from the cured composition.

In another embodiment, the pattern forming process includes a step of applying the curable composition for transfer materials to a substrate to form a coating layer; a step of pressing a mold into the curable composition that has been applied to the substrate; a step of applying an active energy ray to the curable composition while keeping the mold pressed in the composition, thereby to cure the curable composition; and a step of separating the mold from the cured composition.

### [1. Application step]

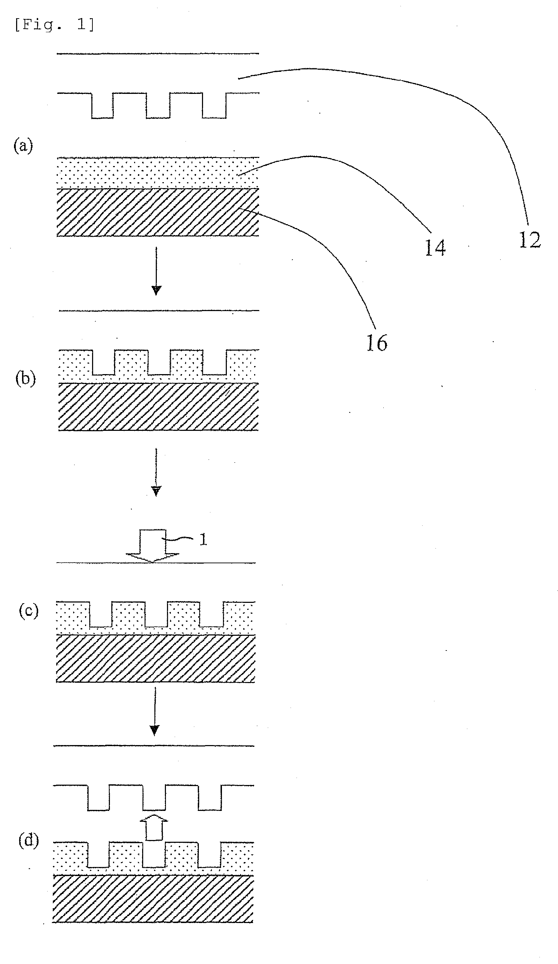

The curable composition may be applied to a substrate by any methods without limitation, for example by spin coating or dip coating. It is preferable to adopt a method capable of spreading the curable composition on a substrate to form a coating layer in a uniform thickness. Fig. 1 (a) illustrates the curable composition of the invention applied on a substrate, in detail a coating layer 14 formed on a substrate 16. The substrate herein refers to a substrate which has a layer to be patterned such as a magnetic layer and/or a protective layer on a base such as a glass plate.

### [2. Transfer step and curing step]

Fine patterns may be fabricated by pressing a finely patterned mold to the coating layer (thereby transferring the patterns). After the mold is pressed into the coating layer, the curable composition is cured with active energy rays or heat, or both in combination, namely by applying active energy rays under heating. Figs. 1 (b) and (c) show steps in which a mold is pressed into the curable composition applied to the substrate, and the composition is cured by irradiation of active energy rays and/or heating. Fig. 1 (b) illustrates a mold 12 that is in pressed contact with the coating layer 14 on the substrate 16. In Fig. 1 (c), active energy rays are applied to the coating layer 14 or heat is applied thereto while the mold 12 is kept in contact with the coating layer 14. An arrow 1 shows the direction in which the energy rays and/or heat is applied.

The mold may be formed of any materials without limitation. However, when the curable composition is cured with active energy rays such as UV rays, molds made of resin, glass or quartz which transmits active energy rays are preferable because the active energy rays can be transmitted to the coating layer through the mold from its side that is opposite to the side thereof in contact with the coating layer and thereby the curable composition can be cured and form fine patterns even when the substrate used does not transmit active energy rays. That is, referring to Fig. 1 (c), active energy rays are applied from above the mold 12 and reach the finely patterned coating layer 14 through the mold 12. When the substrate is, for example, a transparent substrate that transmits active energy rays, the curing is usually performed by applying active energy rays from the side of the substrate that is opposite to the side thereof in contact with the coating layer, to the coating layer through the substrate. That is, referring to Fig. 1 (c), active energy rays are applied from below the substrate 16 and reach the finely patterned coating layer 14 through the substrate 16.

The active energy rays used in the invention are not particularly limited as long as they can cure the composition by acting on the (meth) acryloyl groups or the (meth) acrylamide groups of the curable silicon compound. Examples include radiations such as UV rays and X-rays, and electron beams. Of these, UV rays and electron beams may be suitably used.

The composition may be pressed with a mold, or heated or irradiated with energy rays in any atmosphere without limitation. However, vacuum atmosphere is preferable to prevent any bubbles from remaining in the cured composition. When the curable functional groups are carbon-carbon double bonds such as in (meth)acryloyl groups, allyl groups or vinyl groups, the mold pressing and the subsequent heating or energy ray irradiation are preferably performed in vacuum to prevent polymerization inhibition by oxygen.

### [3. Separation step]

After the coating layer of the curable composition is cured, the mold is separated from the coating layer. Fig. 1 (d) illustrates the cured and finely patterned coating layer 14, the mold 12 having been separated therefrom. After the mold is separated, the substrate may be heated to increase the heat resistance or physical strength of the fine patterns. The heating method is not particularly limited. In a preferred embodiment, the temperature is slowly increased but is kept below the glass transition temperature of the coating layer to avoid the deformation of the patterns, and the upper limit of the heating temperature is 250°C to prevent thermal decomposition of the coating layer.

Fine patterns of 10 µm or less may be fabricated as described above. The fine patterns are cured products of the curable composition for transfer materials according to the invention and show high etching resistance against argon gas. Further, the fine patterns have high selectivity of etching rate between by argon gas and by oxygen gas. In detail, the fine patterns of 10 µm or less that are fabricated by the fine pattern forming process of the invention have high resistance against etching gas (argon gas) to facilitate controlling the etching level, and meanwhile have low resistance against gas (oxygen gas) used for the removal thereof to permit easy removal. Accordingly, the fine patterns having high selectivity of etching rate can make excellent resists, finding wide use in applications such as semiconductors and magnetic recording media.

As described above, the curable compositions for transfer materials of the invention may be used in wide applications including magnetic recording media. In more detail, the fine patterns may be used in the processing for partial removal or partial demagnetization of magnetic layers of magnetic recording media. Such processing is described below.

### (1. Perforation)

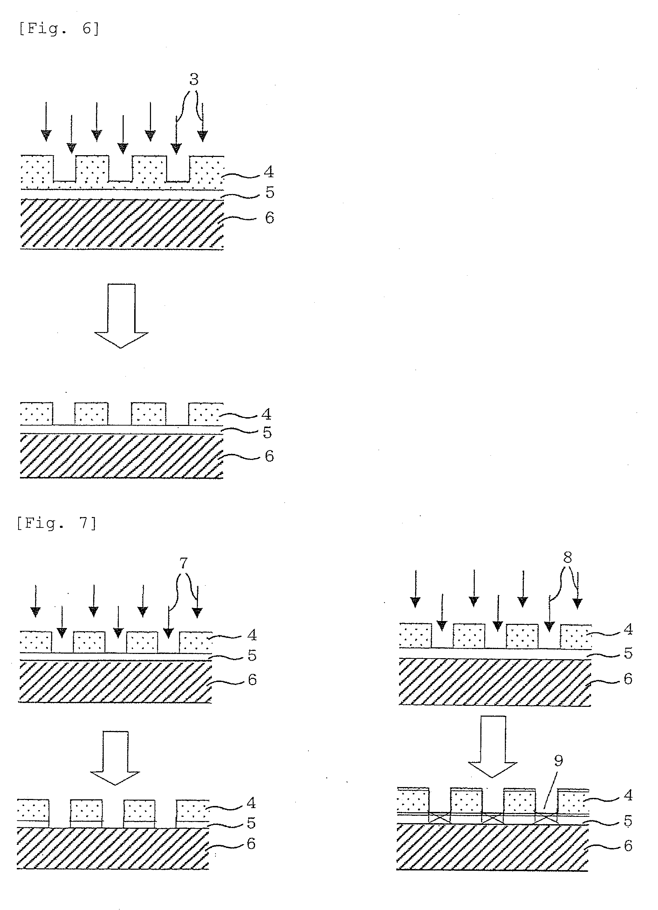

The cured composition is subjected to ion etching (RIE or ion milling) to etch the depressions in the patterns, thereby exposing the surface of a magnetic layer. Fig. 6 is a schematic illustration of this step. Referring to Fig. 6, a substrate includes a base 6 and a magnetic layer 5, and a cured layer 4 which has fine patterns formed from the curable composition of the invention is provided on the magnetic layer 5. Reactive ion etching is performed from above the cured layer 4 (the upper illustration in Fig. 6). An arrow 3 indicates the direction in which the reactive ion etching is performed. As a result of the etching, the depressions in the fine patterns of the cured layer 4 are etched and consequently the cured layer on the magnetic layer is removed corresponding to the fine patterns (the lower illustration in Fig. 6).

### (2. Partial removal or partial demagnetization of magnetic layers)

The exposed magnetic parts are etched by ion milling or are demagnetized with a reactive gas. Here, the cured composition should be resistant to ion milling and reactive gas. Fig. 7 schematically illustrates this step. The left illustration in Fig. 7 shows an ion milling (ion etching) step, in which the finely patterned and perforated cured layer 4 is ion milled from thereabove (the upper left illustration in Fig. 7) and the magnetic layer exposed from the cured layer is etched (the lower left illustration in Fig. 7). An arrow 7 indicates the direction in which the ion milling is performed. The right illustration in Fig. 7 shows a demagnetization step using a reactive gas, in which the finely patterned and perforated cured layer 4 is processed with a reactive gas from thereabove (the upper right illustration in Fig. 7) and the magnetic layer exposed from the cured layer is demagnetized to a nonmagnetic layer 9 (the lower right illustration in Fig. 7). An arrow 8 indicates the direction in which the reactive gas is supplied. In an exemplary method of demagnetizing the magnetic parts, atoms such as silicon, boron, fluorine, phosphorus, tungsten, carbon, indium, germanium, bismuth, krypton and argon are injected to the magnetic parts by an ion beam method or the like to render the magnetic parts amorphous, as described in JP-A-2007-273067.

The layer of the cured composition is thereafter removed, and a magnetic recording media is thus manufactured.

The incorporation of the magnetic recording media produced by the above process into magnetic recording/reading apparatuses achieves a drastically increased recording density of the magnetic recording/reading apparatuses while ensuring recording/reading properties that are comparable or superior to the conventional level.

### EXAMPLES

The present invention will be described in detail by presenting examples hereinbelow without limiting the scope of the invention.

### [Example 1]

12.6 g (0.1 mol) of melamine, 78.1 g (0.67 mol) of hydroxyethyl acrylate, 18.9 g (0.6 mol) of paraformaldehyde, 0.33 g (1.74 mmol) of paratoluenesulfonic acid monohydrate and 20 mg (1.61 mmol) of paramethoxyphenol were weighed into a 300 mL three-necked flask. A Liebig condenser equipped with an evaporation flask was connected to the three-necked flask. The three-necked flask was then immersed in an oil bath set at 115°C, and reaction was carried out while the mixture liquid was bubbled and stirred with dry air. With the progress of the reaction, water accumulated in the evaporation flask that was attached to the Liebig condenser connected with the three-necked flask. When the reaction was performed for 7 hours, the evaporation of water from the reaction system was confirmed to have ceased. The three-necked flask was then lifted from the oil bath, and the reaction was terminated.

950 parts by mass of propylene glycol monomethyl ether acetate and 1.5 parts by mass of 2-benzyl-2-dimethylamino-1-(4-morpholinophenyl)-1-butanone (IRGACURE 369 manufactured by Ciba Japan K.K.) were added to and dissolved in 50 parts by mass of the reaction liquid. The resultant solution was filtered through a 0.2 µm filter to give a curable composition. The curable composition in a volume of 0.5 ml was dropped onto a glass substrate set in a spin coater, and the glass substrate was rotated at 500 rpm for 5 seconds, 3000 rpm for 2 seconds and 5000 rpm for 20 seconds, thereby forming a thin layer on the glass substrate. The glass substrate on which the curable composition formed a thin layer was irradiated with UV ray (365 nm wavelength and 35 mW/cm² dose) for 15 seconds in a stream of nitrogen. The thin resin layer was etched by a method described later to determine the ion etching rate by argon gas and that by oxygen gas.

### [Example 2]

950 parts by mass of propylene glycol monomethyl ether acetate and 1.5 parts by mass of dicumyl peroxide (PERCUMYL D manufactured by NOF CORPORATION) were added to and dissolved in 50 parts by mass of the reaction liquid obtained in Example 1. The resultant solution was filtered through a 0.2 µm filter to give a curable composition. The curable composition in a volume of 0.5 ml was dropped onto a glass substrate set in a spin coater, and the glass substrate was rotated at 500 rpm for 5 seconds, 3000 rpm for 2 seconds and 5000 rpm for 20 seconds, thereby forming a thin layer on the glass substrate. The glass substrate on which the curable composition formed a thin layer was heated in an inert oven at 160°C for 1 hour and at 250°C for 1 hour in a stream of nitrogen. The thin resin layer was etched by a method described later to determine the ion etching rate by argon gas and that by oxygen gas.

### [Example 3]

12.6 g (0.1 mol) of melamine, 78.1 g (0.6 mol) of 2-hydroxypropyl acrylate, 18.9 g (0. 6 mol) of paraformaldehyde, 0.33 g (1.74 mmol) of paratoluenesulfonic acid monohydrate and 20 mg (1.61 mmol) of paramethoxyphenol were weighed into a 300 mL three-necked flask. A Liebig condenser equipped with an evaporation flask was connected to the three-necked flask. The three-necked flask was then immersed in an oil bath set at 115°C, and reaction was carried out while the mixture liquid was bubbled and stirred with dry air. With the progress of the reaction, water accumulated in the evaporation flask that was attached to the Liebig condenser connected with the three-necked flask. When the reaction was performed for 7 hours, the evaporation of water from the reaction system was confirmed to have ceased. The three-necked flask was then lifted from the oil bath, and the reaction was terminated.

950 parts by mass of propylene glycol monomethyl ether acetate and 1.5 parts by mass of 2-benzyl-2-dimethylamino-1-(4-morpholinophenyl)-1-butanone (IRGACURE 369 manufactured by Ciba Japan K.K.) were added to and dissolved in 50 parts by mass of the reaction liquid. The resultant solution was filtered through a 0.2 µm filter to give a curable composition. The curable composition in a volume of 0.5 ml was dropped onto a glass substrate set in a spin coater, and the glass substrate was rotated at 500 rpm for 5 seconds, 3000 rpm for 2 seconds and 5000 rpm for 20 seconds, thereby forming a thin layer on the glass substrate. The glass substrate on which the curable composition formed a thin layer was irradiated with UV ray (365 nm wavelength and 35 mW/cm² dose) for 15 seconds in a stream of nitrogen. The thin resin layer was etched by a method described later to determine the ion etching rate by argon gas and that by oxygen gas.

### [Example 4]

950 parts by mass of propylene glycol monomethyl ether acetate and 1.5 parts by mass of dicumyl peroxide (PERCUMYL D manufactured by NOF CORPORATION) were added to and dissolved in 50 parts by mass of the reaction liquid obtained in Example 3. The resultant solution was filtered through a 0.2 µm filter to give a curable composition. The curable composition in a volume of 0.5 ml was dropped onto a glass substrate set in a spin coater, and the glass substrate was rotated at 500 rpm for 5 seconds, 3000 rpm for 2 seconds and 5000 rpm for 20 seconds, thereby forming a thin layer on the glass substrate. The glass substrate on which the curable composition formed a thin layer was heated in an inert oven at 160°C for 1 hour and at 250°C for 1 hour in a stream of nitrogen. The thin resin layer was etched by a method described later to determine the ion etching rate by argon gas and that by oxygen gas.

### [Example 5]

12.6 g (0.1 mol) of melamine, 118.96 g (0.6 mol) of 1,4-cyclohexanedimethanol monoacrylate, 18.9 g (0.6 mol) of paraformaldehyde, 0.33 g (1.74 mmol) of paratoluenesulfonic acid monohydrate and 20 mg (1.61 mmol) of paramethoxyphenol were weighed into a 300 mL three-necked flask. A Liebig condenser equipped with an evaporation flask was connected to the three-necked flask. The three-necked flask was then immersed in an oil bath set at 115°C, and reaction was carried out while the mixture liquid was bubbled and stirred with dry air. With the progress of the reaction, water accumulated in the evaporation flask that was attached to the Liebig condenser connected with the three-necked flask. When the reaction was performed for 7 hours, the evaporation of water from the reaction system was confirmed to have ceased. The three-necked flask was then lifted from the oil bath, and the reaction was terminated.

950 parts by mass of propylene glycol monomethyl ether acetate and 1.5 parts by mass of 2-benzyl-2-dimethylamino-1-(4-morpholinophenyl)-1-butanone (IRGACURE 369 manufactured by Ciba Japan K.K.) were added to and dissolved in 50 parts by mass of the reaction liquid. The resultant solution was filtered through a 0.2 µm filter to give a curable composition. The curable composition in a volume of 0.5 ml was dropped onto a glass substrate set in a spin coater, and the glass substrate was rotated at 500 rpm for 5 seconds, 3000 rpm for 2 seconds and 5000 rpm for 20 seconds, thereby forming a thin layer on the glass substrate. The glass substrate on which the curable composition formed a thin layer was irradiated with UV ray (365 nm wavelength and 35 mW/cm² dose) for 15 seconds in a stream of nitrogen. The thin resin layer was etched by a method described later to determine the ion etching rate by argon gas and that by oxygen gas.

### [Example 6]

950 parts by mass of propylene glycol monomethyl ether acetate and 1.5 parts by mass of dicumyl peroxide (PERCUMYL D manufactured by NOF CORPORATION) were added to and dissolved in 50 parts by mass of the reaction liquid obtained in Example 5. The resultant solution was filtered through a 0.2 µm filter to give a curable composition. The curable composition in a volume of 0.5 ml was dropped onto a glass substrate set in a spin coater, and the glass substrate was rotated at 500 rpm for 5 seconds, 3000 rpm for 2 seconds and 5000 rpm for 20 seconds, thereby forming a thin layer on the glass substrate. The glass substrate on which the curable composition formed a thin layer was heated in an inert oven at 160°C for 1 hour and at 250°C for 1 hour in a stream of nitrogen. The thin resin layer was etched by a method described later to determine the ion etching rate by argon gas and that by oxygen gas.

### [Comparative Example 1]

950 parts by mass of propylene glycol monomethyl ether acetate and 1.5 parts by mass of 2-benzyl-2-dimethylamino-1-(4-morpholinophenyl)-1-butanone (IRGACURE 369 manufactured by Ciba Japan K.K.) were added to and dissolved in 50 parts by mass of dipentaerythritol hexaacrylate (KAYARAD DPHA manufactured by NIPPON KAYAKU Co., Ltd.). The solution was filtered through a 0.2 µm filter. The resultant curable composition in a volume of 0.5 ml was dropped onto a glass substrate set in a spin coater, and the glass substrate was rotated at 500 rpm for 5 seconds, 3000 rpm for 2 seconds and 5000 rpm for 20 seconds, thereby forming a thin layer on the glass substrate. The glass substrate coated with the resin was irradiated with UV ray (365 nm wavelength and 35 mW/cm² dose) for 15 seconds in a stream of nitrogen. The thin resin layer was etched by a method described later to determine the ion etching rate by argon gas and that by oxygen gas.

### (Method of measuring etching rates)

A glass piece was attached to the cured thin layer, and etching was performed using an ion etching apparatus under the following conditions. Thereafter, the glass piece was removed, and the difference in level was measured between a portion of the thin layer that had been protected with the glass piece and a portion thereof that had been etched.

Etching rate (nm/sec) = step (nm) ÷ processing time (sec) Ion etching conditions
(Argon gas)
Etching gas: argon
Pressure: 0.5 Pa
Gas flow rate: 40 sccm
Plasma voltage: 200 W
Bias voltage: 20 W
Processing time: 200 sec
(Oxygen gas)
Etching gas: oxygen
Pressure: 0.5 Pa
Gas flow rate: 40 sccm
Plasma voltage: 200 W
Bias voltage: 20 W
Processing time: 20 sec
Table 1 sets forth the etching rates by the gases in Examples 1 to 6 and Comparative Example 1.
The thin resin layers of Examples 1 to 6 showed high argon etching resistance, and the argon etching rates thereof were approximately 1/2 that of the thin resin layer of Comparative Example 1. Further, the ratios between the oxygen and argon etching rates of the thin resin layers of Examples 1 to 6 were higher than that in Comparative Example 1. These results show that the cured layers obtained from the curable compositions for transfer materials of the invention have higher argon resistance and higher etching selectivity compared to the cured layer of Comparative Example, and thus they may be suitably used as resists.

[Table 1]

**Table 1**

| | Ex. 1 | Ex. 2 | Ex. 3 | Ex. 4 | Ex. 5 | Ex. 6 | Comp. Ex. 1 |
|---|---|---|---|---|---|---|---|
| O₂ etching rate (nm/sec) | 2.61 | 3.02 | 2.34 | 2.56 | 2.18 | 3.06 | 3.95 |
| Ar etching rate (nm/sec) | 0.17 | 0.15 | 0.15 | 0.18 | 0.13 | 0.17 | 0.31 |
| Etching selectivity (O₂/Ar) | 15.4 | 20.1 | 15.6 | 14.2 | 16.8 | 18.0 | 12.7 |

### [Example 7]

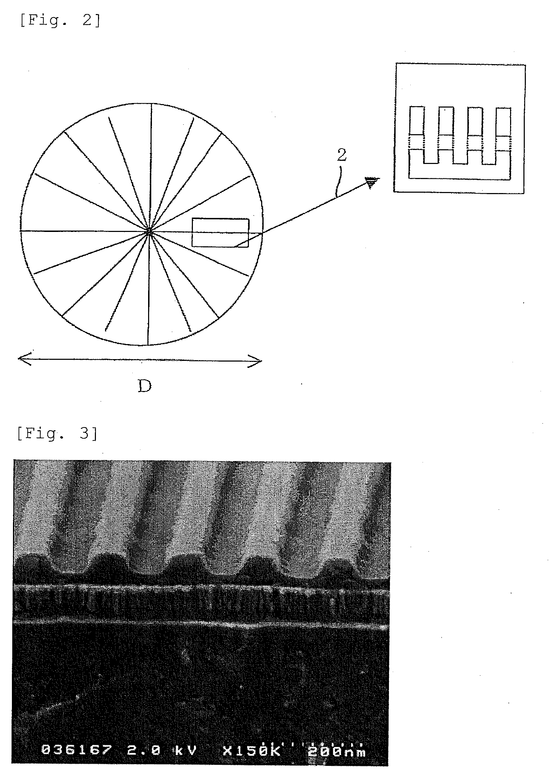

950 parts by mass of propylene glycol monomethyl ether acetate and 1.5 parts by mass of 2-benzyl-2-dimethylamino-1-(4-morpholinophenyl)-1-butanone (IRGACURE 369 manufactured by Ciba Japan K.K.) were added to and dissolved in 50 parts by mass of the reaction liquid obtained in Example 1. The solution was filtered through a 0.2 µm filter. The resultant curable composition in a volume of 0.5 ml was dropped onto a glass substrate set in a spin coater, and the glass substrate was rotated at 500 rpm for 5 seconds, 3000 rpm for 2 seconds and 5000 rpm for 20 seconds, thereby forming a thin layer on the glass substrate. A quartz glass mold as shown in Fig. 2 in which projections and depressions were patterned (the depth of the depressions: 150 nm) along the radial direction of the mold was placed, with the patterned surface downward, on the resin-coated surface of the glass substrate with the curable composition layer. They were set in UV nanoimprinting press machine ST200 (manufactured by TOSHIBA MACHINE CO., LTD.) and pressed together, and UV ray with 365 nm wavelength and 6.5 mW/cm² intensity was applied from above the patterned mold. The diameter D of the mold was 1.8 inch. The mold had L/S = 80 nm/120 nm, and a linewidth of 0.1 mm. The illustration on the right of an arrow 2 in Fig. 2 is an enlarged view of the portion enclosed with a square on the left of the arrow 2. In this enlarged view, the upper illustration is a schematic plane view, and the lower illustration is a schematic cross sectional view. The circular plate with the mold thereon was removed from the press machine, and the mold was separated. The coating layer on the glass circular plate was observed and was found to be free of defects such as transfer failure or unevenness of the coating layer. Fig. 3 shows a scanning electron micrograph (SEM) of a cross section of the transferred substrate. As shown in Fig. 3, the rectangular patterns of the mold were excellently transferred.

### [Example 8]

950 parts by mass of propylene glycol monomethyl ether acetate and 1.5 parts by mass of 2-benzyl-2-dimethylamino-1-(4-morpholinophenyl)-1-butanone (IRGACURE 369 manufactured by Ciba Japan K.K.) were added to and dissolved in 50 parts by mass of the reaction liquid obtained in Example 2. The solution was filtered through a 0.2 µm filter. The resultant curable composition in a volume of 0.5 ml was dropped onto a glass substrate set in a spin coater, and the glass substrate was rotated at 500 rpm for 5 seconds, 3000 rpm for 2 seconds and 5000 rpm for 20 seconds, thereby forming a thin layer on the glass substrate. A quartz glass mold as shown in Fig. 2 in which projections and depressions were patterned (the depth of the depressions: 150 nm) along the radial direction of the mold was placed, with the patterned surface downward, on the resin-coated surface of the glass substrate with the curable composition layer. They were set in UV nanoimprinting press machine ST200 (manufactured by TOSHIBA MACHINE CO., LTD.) and pressed together, and UV ray with 365 nm wavelength and 6.5 mW/cm² intensity was applied from above the patterned mold. The circular plate with the mold thereon was removed from the press machine, and the mold was separated. The coating layer on the glass circular plate was observed and was found to be free of defects such as transfer failure or unevenness of the coating layer.

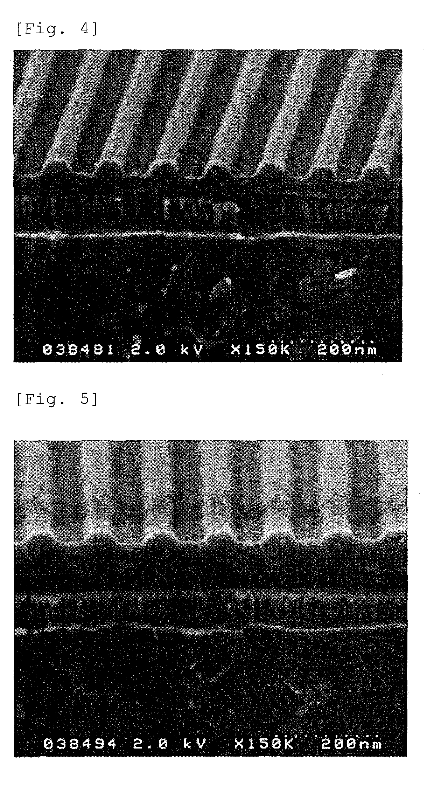

Fig. 4 shows a scanning electron micrograph (SEM) of a cross section of the transferred substrate. As shown in Fig. 4, the rectangular patterns of the mold were excellently transferred.

### [Example 9]

950 parts by mass of propylene glycol monomethyl ether acetate and 1.5 parts by mass of 2-benzyl-2-dimethylamino-1-(4-morpholinophenyl)-1-butanone (IRGACURE 369 manufactured by Ciba Japan K.K.) were added to and dissolved in 50 parts by mass of the reaction liquid obtained in Example 3. The solution was filtered through a 0.2 µm filter. The resultant curable composition in a volume of 0.5 ml was dropped onto a glass substrate set in a spin coater, and the glass substrate was rotated at 500 rpm for 5 seconds, 3000 rpm for 2 seconds and 5000 rpm for 20 seconds, thereby forming a thin layer on the glass substrate. A quartz glass mold as shown in Fig. 2 in which projections and depressions were patterned (the depth of the depressions: 150 nm) along the radial direction of the mold was placed, with the patterned surface downward, on the resin-coated surface of the glass substrate with the curable composition layer. They were set in UV nanoimprinting press machine ST200 (manufactured by TOSHIBA MACHINE CO., LTD.) and pressed together, and UV ray with 365 nm wavelength and 6.5 mW/cm² intensity was applied from above the patterned mold. The circular plate with the mold thereon was removed from the press machine, and the mold was separated. The coating layer on the glass circular plate was observed and was found to be free of defects such as transfer failure or unevenness of the coating layer.

Fig. 5 shows a scanning electron micrograph (SEM) of a cross section of the transferred substrate. As shown in Fig. 5, the rectangular patterns of the mold were excellently transferred.

### [Example 10]

3.0 g (0.024 mol) of melamine, 8.29 g (0.071 mol) of hydroxyethyl acrylate, 4.3 g (0.143 mol) of paraformaldehyde, 8.44 g (0.071 mol) of 2-(trimethylsilyl)ethanol, 0.1 g (0.53 mmol) of paratoluenesulfonic acid monohydrate and 10 mg (0.81 mmol) of paramethoxyphenol were weighed into a 200 mL three-necked flask. A Liebig condenser equipped with an evaporation flask was connected to the three-necked flask. The three-necked flask was then immersed in an oil bath set at 115°C, and reaction was carried out while the mixture liquid was bubbled and stirred with dry air. With the progress of the reaction, water accumulated in the evaporation flask that was attached to the Liebig condenser connected with the three-necked flask. When the reaction was performed for 7 hours, the evaporation of water from the reaction system was confirmed to have ceased. The three-necked flask was then lifted from the oil bath, and the reaction was terminated. Thereafter, 950 parts by mass of propylene glycol monomethyl ether acetate and 1.5 parts by mass of 2-benzyl-2-dimethylamino-1-(4-morpholinophenyl)-1-butanone (IRGACURE 369 manufactured by Ciba Japan K.K.) were added to and dissolved in 50 parts by mass of the reaction liquid. The resultant solution was filtered through a 0.2 µm filter to give a curable composition. The curable composition in a volume of 0.5 ml was dropped onto a glass substrate set in a spin coater, and the glass substrate was rotated at 500 rpm for 5 seconds, 3000 rpm for 2 seconds and 5000 rpm for 20 seconds, thereby forming a thin layer on the glass substrate. The thickness of the layer was approximately 0.2 µm. The glass substrate on which the curable composition formed a thin layer was irradiated with UV ray (365 nm wavelength and 35 mW/cm² dose) for 15 seconds in a stream of nitrogen. The thin resin layer was etched by the method described in Examples 1 to 6 and Comparative Example 1 to determine the reactive ion etching rate by argon gas and that by oxygen gas.

### [Example 11]

3.0 g (0.024 mol) of melamine, 11.05 g (0.095 mol) of hydroxyethyl acrylate, 4.3 g (0.14 mol) of paraformaldehyde, 5.6 g (0.047 mol) of 2-(trimethylsilyl)ethanol, 0.1 g (0.53 mmol) of paratoluenesulfonic acid monohydrate and 10 mg (0.81 mmol) of paramethoxyphenol were weighed into a 200 mL three-necked flask. A Liebig condenser equipped with an evaporation flask was connected to the three-necked flask. The three-necked flask was then immersed in an oil bath set at 115°C, and reaction was carried out while the mixture liquid was bubbled and stirred with dry air. With the progress of the reaction, water accumulated in the evaporation flask that was attached to the Liebig condenser connected with the three-necked flask. When the reaction was performed for 7 hours, the evaporation of water from the reaction system was confirmed to have ceased. The three-necked flask was then lifted from the oil bath, and the reaction was terminated. Thereafter, 950 parts by mass of propylene glycol monomethyl ether acetate and 1.5 parts by mass of 2-benzyl-2-dimethylamino-1-(4-morpholinophenyl)-1-butanone (IRGACURE 369 manufactured by Ciba Japan K.K.) were added to and dissolved in 50 parts by mass of the reaction liquid. The resultant solution was filtered through a 0.2 µm filter to give a curable composition. The curable composition in a volume of 0.5 ml was dropped onto a glass substrate set in a spin coater, and the glass substrate was rotated at 500 rpm for 5 seconds, 3000 rpm for 2 seconds and 5000 rpm for 20 seconds, thereby forming a thin layer on the glass substrate. The thickness of the layer was approximately 0.2 µm. The glass substrate on which the curable composition formed a thin layer was irradiated with UV ray (365 nm wavelength and 35 mW/cm² dose) for 15 seconds in a stream of nitrogen. The thin resin layer was etched by the method described in Examples 1 to 6 and Comparative Example 1 to determine the reactive ion etching rate by argon gas and that by oxygen gas.

### [Example 12]

4.0 g (0.032 mol) of melamine, 18.4 g (0.158 mol) of hydroxyethyl acrylate, 5.7 g (0.189 mol) of paraformaldehyde, 3.75 g (0.032 mol) of 2-(trimethylsilyl)ethanol, 0.13 g (0.69 mmol) of paratoluenesulfonic acid monohydrate and 13 mg (1.05 mmol) of paramethoxyphenol were weighed into a 200 mL three-necked flask. A Liebig condenser equipped with an evaporation flask was connected to the three-necked flask. The three-necked flask was then immersed in an oil bath set at 115°C, and reaction was carried out while the mixture liquid was bubbled and stirred with dry air. With the progress of the reaction, water accumulated in the evaporation flask that was attached to the Liebig condenser connected with the three-necked flask. When the reaction was performed for 7 hours, the evaporation of water from the reaction system was confirmed to have ceased. The three-necked flask was then lifted from the oil bath, and the reaction was terminated. Thereafter, 950 parts by mass of propylene glycol monomethyl ether acetate and 1.5 parts by mass of 2-benzyl-2-dimethylamino-1-(4-morpholinophenyl)-1-butanone (IRGACURE 369 manufactured by Ciba Japan K.K.) were added to and dissolved in 50 parts by mass of the reaction liquid. The resultant solution was filtered through a 0.2 µm filter to give a curable composition. The curable composition in a volume of 0.5 ml was dropped onto a glass substrate set in a spin coater, and the glass substrate was rotated at 500 rpm for 5 seconds, 3000 rpm for 2 seconds and 5000 rpm for 20 seconds, thereby forming a thin layer on the glass substrate. The thickness of the layer was approximately 0.2 µm. The glass substrate on which the curable composition formed a thin layer was irradiated with UV ray (365 nm wavelength and 35 mW/cm² dose) for 15 seconds in a stream of nitrogen. The thin resin layer was etched by the method described in Examples 1 to 6 and Comparative Example 1 to determine the reactive ion etching rate by argon gas and that by oxygen gas.
Table 2 sets forth the etching rates by the gases in Examples 10 to 12 and Comparative Example 1.
The thin resin layers of Examples 10 to 12 had a low argon etching rate, approximately 1/3 to 1/2 compared to that of the thin resin layer of Comparative Example 1, and showed a tendency that the argon etching resistance was higher with increasing amount of the compound (D) having a hydroxyl group and a silicon atom in the molecule. However, the oxygen etching resistance was also increased by the addition of the compound (D) having a hydroxyl group and a silicon atom in the molecule. Accordingly, these compositions are suited for applications requiring high argon resistance rather than the etching selectivity.

[Table 2]

**Table 2**

| | Ex. 10 | Ex. 11 | Ex. 12 | Comp. Ex. 1 |
|---|---|---|---|---|
| O₂ etching rate (nm/sec) | 0.57 | 1.42 | 2.16 | 3.95 |
| Ar etching rate (nm/sec) | 0.11 | 0.14 | 0.18 | 0.31 |
| Etching selectivity (O₂/Ar) | 5.18 | 10.1 | 12.0 | 12.7 |

### [Example 13]

950 parts by mass of propylene glycol monomethyl ether acetate and 1.5 parts by mass of 2-benzyl-2-dimethylamino-1-(4-morpholinophenyl)-1-butanone (IRGACURE 369 manufactured by Ciba Japan K.K.) were added to and dissolved in 50 parts by mass of the reaction liquid obtained in Example 10. The solution was filtered through a 0.2 µm filter. The resultant curable composition in a volume of 0.5 ml was dropped onto a glass substrate set in a spin coater, and the glass substrate was rotated at 500 rpm for 5 seconds, 3000 rpm for 2 seconds and 5000 rpm for 20 seconds, thereby forming a thin layer on the glass substrate. A quartz glass mold as shown in Fig. 2 in which projections and depressions were patterned (the depth of the depressions: 150 nm) along the radial direction of the mold was placed, with the patterned surface downward, on the resin-coated surface of the glass substrate with the curable composition layer. They were set in UV nanoimprinting press machine ST200 (manufactured by TOSHIBA MACHINE CO., LTD.) and pressed together, and UV ray with 365 nm wavelength and 6.5 mW/cm² intensity was applied. The circular plate with the mold thereon was removed from the press machine, and the mold was separated. The coating layer on the glass circular plate was observed and was found to be free of defects such as transfer failure or unevenness of the coating layer.

### [Example 14]

950 parts by mass of propylene glycol monomethyl ether acetate and 1.5 parts by mass of 2-benzyl-2-dimethylamino-1-(4-morpholinophenyl)-1-butanone (IRGACURE 369 manufactured by Ciba Japan K.K.) were added to and dissolved in 50 parts by mass of the reaction liquid obtained in Example 11. The solution was filtered through a 0.2 µm filter. The resultant curable composition in a volume of 0.5 ml was dropped onto a glass substrate set in a spin coater, and the glass substrate was rotated at 500 rpm for 5 seconds, 3000 rpm for 2 seconds and 5000 rpm for 20 seconds, thereby forming a thin layer on the glass substrate. A quartz glass mold as shown in Fig. 2 in which projections and depressions were patterned (the depth of the depressions: 150 nm) along the radial direction of the mold was placed, with the patterned surface downward, on the resin-coated surface of the glass substrate with the curable composition layer. They were set in UV nanoimprinting press machine ST200 (manufactured by TOSHIBA MACHINE CO., LTD.) and pressed together, and UV ray with 365 nm wavelength and 6.5 mW/cm² intensity was applied. The circular plate with the mold thereon was removed from the press machine, and the mold was separated. The coating layer on the glass circular plate was observed and was found to be free of defects such as transfer failure or unevenness of the coating layer.

### [Example 15]

950 parts by mass of propylene glycol monomethyl ether acetate and 1.5 parts by mass of 2-benzyl-2-dimethylamino-1-(4-morpholinophenyl)-1-butanone (IRGACURE 369 manufactured by Ciba Japan K.K.) were added to and dissolved in 50 parts by mass of the reaction liquid obtained in Example 12. The solution was filtered through a 0.2 µm filter. The resultant curable composition in a volume of 0.5 ml was dropped onto a glass substrate set in a spin coater, and the glass substrate was rotated at 500 rpm for 5 seconds, 3000 rpm for 2 seconds and 5000 rpm for 20 seconds, thereby forming a thin layer on the glass substrate. A quartz glass mold as shown in Fig. 2 in which projections and depressions were patterned (the depth of the depressions: 150 nm) along the radial direction of the mold was placed, with the patterned surface downward, on the resin-coated surface of the glass substrate with the curable composition layer. They were set in UV nanoimprinting press machine ST200 (manufactured by TOSHIBA MACHINE CO., LTD.) and pressed together, and UV ray with 365 nm wavelength and 6.5 mW/cm² intensity was applied. The circular plate with the mold thereon was removed from the press machine, and the mold was separated. The coating layer on the glass circular plate was observed and was found to be free of defects such as transfer failure or unevenness of the coating layer.

### Reference Signs List

4: cured layer
5: magnetic layer
6: base
12: mold
14: coating layer of curable composition for transfer materials
16: substrate

## Claims

1. A curable composition for transfer materials which comprises a (meth)acrylate compound having a triazine skeleton, the compound being obtainable by reacting an aminotriazine compound, a compound having a hydroxyl group and a (meth)acryloyl group in the molecule, and an aldehyde.

2. A curable composition for transfer materials which comprises a (meth)acrylate compound having a triazine skeleton, the compound being obtainable by reacting an aminotriazine compound, a compound having a hydroxyl group and a (meth)acryloyl group in the molecule, an aldehyde, and a compound having a hydroxyl group and a silicon atom in the molecule.

3. The curable composition for transfer materials according to claim 2, wherein the compound having a hydroxyl group and a silicon atom in the molecule is at least one selected from trimethylsilylmethanol, 2-(trimethylsilyl)ethanol, 3-(trimethylsilyl)-1-propanol, 3-(trimethylsilyl)propargyl alcohol, 4-(trimethylsilyl)-1-butanol, 4-(trimethylsilyl)-3-butyn-2-ol, 4-(trimethylsilylethynyl)benzyl alcohol, 5-(trimethylsilyl)-1-pentanol, 5-(trimethylsilyl)-4-pentyn-l-ol, 6-(trimethylsilyl)-1-hexanol, triethylsilylmethanol, 2-(triethylsilyl)ethanol, tripropylsilylmethanol, 2-(tripropylsilyl)ethanol, triisopropylsilylmethanol, 2-(triisopropylsilyl)ethanol, tributylsilylmethanol, 2-(tributylsilyl)ethanol, triphenylsilylmethanol, 2-(triphenylsilyl)ethanol, trimethylsilanol, triethylsilanol, triphenylsilanol, tert-butyldimethylsilylmethanol, 2-(tert-butyldimethylsilyl)ethanol, tert-butyldimethylsilanol, ethyldimethylsilylmethanol, 2-(ethyldimethylsilyl)ethanol, phenyldimethylsilylmethanol, 2-(phenyldimethylsilyl)ethanol and phenyldimethylsilanol.

4. The curable composition for transfer materials according to any one of claims 1 to 3, wherein the aminotriazine compound is melamine.

5. The curable composition for transfer materials according to any one of claims 1 to 4, wherein the compound having a hydroxyl group and a (meth)acryloyl group in the molecule is at least one selected from 2-hydroxyethyl (meth)acrylate, 2-hydroxypropyl (meth)acrylate, 4-hydroxybutyl (meth)acrylate and 1,4-cyclohexanedimethanol mono(meth)acrylate.

6. The curable composition for transfer materials according to any one of claims 1 to 5, wherein the aldehyde is at least one selected from paraformaldehyde, acetaldehyde, butylaldehyde, 3-cyclohexene-1-carboxyaldehyde, cyclohexanecarboxyaldehyde, norbornenecarboxyaldehyde, norbornanecarboxyaldehyde and benzaldehyde.

7. The curable composition for transfer materials according to any one of claims 1 to 6, which further comprises a radically polymerizable compound other than the (meth)acrylate compound having a triazine skeleton.

8. The curable composition for transfer materials according to any one of claims 1 to 7, which further comprises a thermal radical polymerization initiator.

9. The curable composition for transfer materials according to any one of claims 1 to 7, which further comprises an active energy ray radical polymerization initiator.

10. A pattern forming process comprising:
a step of applying the curable composition for transfer materials described in any one of claims 1 to 8 to a substrate to form a coating layer;
a step of pressing a mold having a pattern of projections and depressions on its surface, into the coating layer;
a step of heating the coating layer while keeping the mold pressed in the coating layer, thereby to cure the coating layer; and
a step of separating the mold from the cured coating layer.

11. A pattern forming process comprising:
a step of applying the curable composition for transfer materials described in any one of claims 1 to 7 and 9 to a substrate to form a coating layer;
a step of pressing a mold having a pattern of projections and depressions on its surface, into the coating layer;
a step of applying an active energy ray to the coating layer while keeping the mold pressed in the coating layer, thereby to cure the coating layer; and
a step of separating the mold from the cured coating layer.

12. The pattern forming process according to claim 11, wherein the mold is formed of a material that transmits active energy rays, and the active energy ray is applied to the coating layer through the mold.

13. The pattern forming process according to claim 11, wherein the substrate is formed of a material that transmits active energy rays, and the active energy ray is applied to the coating layer through the substrate.

14. The pattern forming process according to any one of claims 10 to 13, wherein the pattern is a fine pattern of 10 µm or less.

15. A process for manufacturing magnetic recording media, comprising forming a pattern on a magnetic layer of a substrate comprising a base and the magnetic layer thereon, by the pattern forming process described in any one of claims 10 to 14; and removing part of the magnetic layer or demagnetizing part of the magnetic layer using the pattern as a resist.

16. A magnetic recording medium obtainable by the process described in claim 15.

17. A magnetic recording/reading apparatus comprising the magnetic recording medium described in claim 16.
